(19) Europäisches Patentamt / European Patent Office / Office européen des brevets

(11) **EP 2 652 766 B1**

(12) **FASCICULE DE BREVET EUROPEEN**

(45) Date de publication et mention de la délivrance du brevet:
**08.01.2020 Bulletin 2020/02**

(21) Numéro de dépôt: **11811099.8**

(22) Date de dépôt: **13.12.2011**

(51) Int Cl.:
***H01J 27/18*** *(2006.01)*

(86) Numéro de dépôt international:
**PCT/FR2011/052961**

(87) Numéro de publication internationale:
**WO 2012/080650 (21.06.2012 Gazette 2012/25)**

(54) **DISPOSITIF GENERATEUR D'IONS A RESONANCE CYCLOTRONIQUE ELECTRONIQUE**

ELEKTRON-ZYKLOTRON-RESONANZIONENQUELLE

ELECTRONIC CYCLOTRONIC RESONANCE ION SOURCE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **15.12.2010 FR 1060578**

(43) Date de publication de la demande:
**23.10.2013 Bulletin 2013/43**

(73) Titulaire: **Commissariat à l'Énergie Atomique et aux Énergies Alternatives 75015 Paris (FR)**

(72) Inventeurs:
• **DELFERRIERE, Olivier**
  **F-91680 Bruyeres Le Chatel (FR)**
• **TUSKE, Olivier**
  **F-91120 Palaiseau (FR)**
• **HARRAULT, Francis**
  **93170 BAGNOLET (FR)**

(74) Mandataire: **Lebkiri, Alexandre Cabinet Camus Lebkiri 25, Rue de Maubeuge 75009 Paris (FR)**

(56) Documents cités:
**JP-A- 9 055 170    JP-B- 6 019 961**

• **GOBIN R ET AL: "A 140mA cw deuteron electron cyclotron resonance source for the IFMIF-EVEDA project", REVIEW OF SCIENTIFIC INSTRUMENTS, AIP, MELVILLE, NY, US, vol. 79, no. 2, 16 janvier 2008 (2008-01-16), pages 2B303-2B303, XP012115149, ISSN: 0034-6748, DOI: 10.1063/1.2801976**

EP 2 652 766 B1

Printed by Jouve, 75001 PARIS (FR)

## Description

### DOMAINE TECHNIQUE

La présente invention concerne un dispositif générateur d'ions à résonance cyclotronique électronique, et plus précisément une source d'ions monochargés de type ECR ou « Electron Cyclotron Resonance », pour résonance cyclotronique électronique.

### ETAT DE LA TECHNIQUE ANTERIEUR

De façon connue, les dispositifs à résonance cyclotronique électronique, également appelées sources ECR, sont utilisés pour produire des ions mono-chargés ou multichargés (c'est-à-dire des atomes auxquels on a arraché un ou plusieurs électrons).

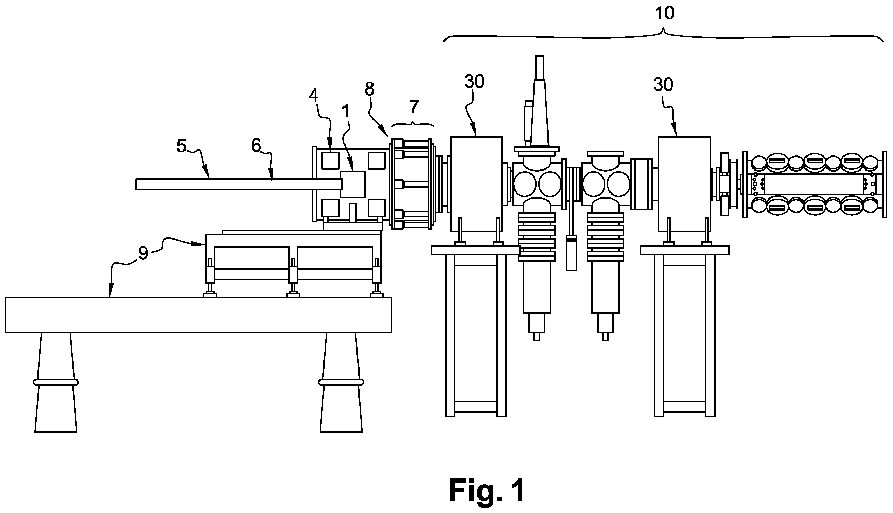

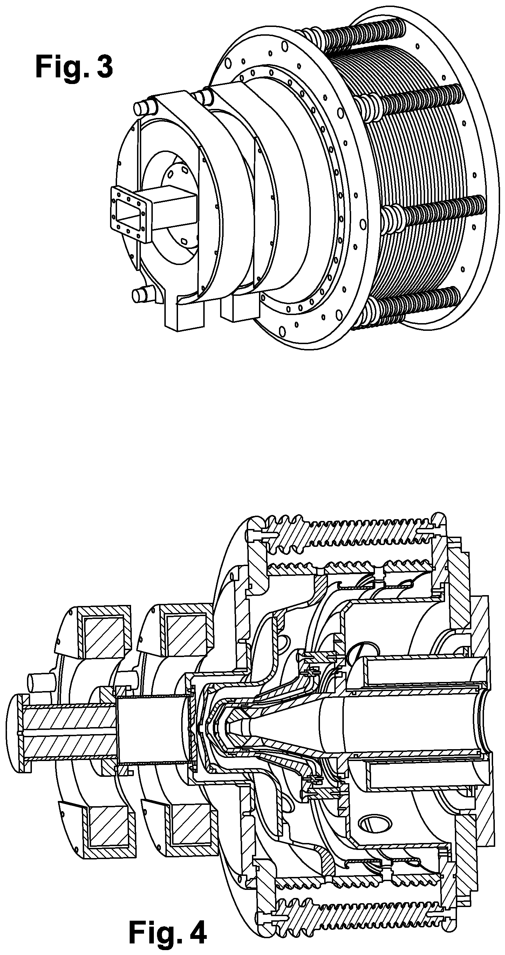

Les figures 1 à 4 représentent un dispositif générateur d'ions à résonance cyclotronique électronique pour la production de faisceaux d'ions mono-chargés de l'art antérieur. Un tel dispositif est par exemple décrit dans les publications suivantes :

" Status and new developments of the high intensity electron cyclotron resonance source light ion continuous wave, and pulsed mode", RSI 71 Vol. 2, 830, Fev. 2000;

"Status of the light ion source developments at CEA-Saclay, » RSI 73 Vol. 5, 1414, May. 2004;

"Electron cyclotron resonance 140 mA D+ beam extraction optimization for IFMIF EVEDA accelerator", RSI 79 02B723, 2008;

"A 140mA cW deuteron electron cyclotron resonance source for the IFMIF-EVEDA Project", Review of Scientific Instruments, Vol. 79, n°2, 16 janvier 2008, page 2B303.

Ce dispositif comporte :

- une chambre plasma 1 destinée à contenir un plasma ;

- des moyens de génération d'un champ magnétique 4 dans la chambre plasma. Ces moyens de génération d'un champ magnétique 4 peuvent comporter des aimants ou des bobines. Ces moyens de génération d'un champ magnétique 4 permettent de créer le champ magnétique nécessaire à la résonnance cyclotronique électronique dans la chambre plasma 1, en entrée de la chambre plasma. Pour cela, les moyens de génération d'un champ magnétique 4 sont généralement placés de façon à ce qu'ils entourent la chambre 1 ;

- des moyens de propagation d'une onde haute-fréquence 5 à l'intérieur de la chambre. Ces moyens de propagation d'une onde haute fréquence comportent généralement un système de génération d'une onde haute fréquence (non représenté) et des moyens de guidage 6 de l'onde haute fréquence jusqu'à l'entrée de la chambre 1. Les moyens de propagation de l'onde haute fréquence 5 sont disposés en amont de la chambre 1.

Dans ce document, les termes « amont » et « aval » sont utilisés en référence au sens de propagation du faisceau d'ions en sortie de la chambre.

La chambre 1 est alimentée en atomes qui peuvent provenir d'un gaz ou d'un métal et les moyens de propagation d'une onde haute-fréquence et les moyens de génération d'un champ magnétique permettent de coupler, à l'intérieur de la chambre une onde haute-fréquence avec un champ magnétique B, de façon à obtenir les conditions dans lesquelles, une résonance cyclotronique électronique est susceptible d'apparaître et d'ioniser les atomes présents, engendrant ainsi un plasma. Pour cela, le champ magnétique en entrée de la chambre doit présenter un module $B_{ecr}$ qui satisfait à la condition (1) de résonance cyclotronique électronique :

$$B_{ecr} = f.2\pi m/e \quad (1)$$

dans laquelle e représente la charge de l'électron, m sa masse et f la fréquence de l'onde électromagnétique.

Afin de permettre la formation des ions dans la chambre, la chambre est à la haute tension, c'est-à-dire à des tensions pouvant aller jusqu'à 100 000 V. Les éléments qui sont connectés à la chambre sont donc également à la haute-tension. En particulier, les moyens de génération d'un champ magnétique, au moins une partie des moyens de propagation d'une onde haute-fréquence sont à la haute-tension.

Les éléments à la haute-tension sont supportés par une plate-forme isolante 9 et par une bride support 8.

Le dispositif générateur d'ions à résonance cyclotronique électronique comporte également un tube accélérateur 7 qui permet de réaliser l'isolation électrique entre la haute-tension et la basse-tension et qui permet d'extraire des ions dans la chambre avec une série d'électrodes 11 permettant de former un faisceau d'ions qui est ensuite dirigé vers une ligne de transport 10 à la basse tension pour être utilisé ou étudié.

Le côté aval du tube accélérateur 7 est connecté à la ligne de transport 10 qui est à la basse tension. Le côté aval du tube accélérateur est à la basse tension.

Le tube accélérateur 7 est disposé en aval de la bride support 8, qui elle-même est disposée en aval de la chambre plasma 1. Le coté amont du tube accélérateur 7 est à la haute-tension.

Le tube accélérateur 7 est constitué de deux ensembles :

- une structure isolante 12 qui maintient mécaniquement le tube accélérateur 7 et qui réalise aussi la tenue sous vide. La structure isolante 12 réalise la coupure électrique entre la haute-tension et la basse tension.

- un système d'extraction du faisceau composé de plusieurs d'électrodes 11.

Afin d'isoler les éléments à la haute-tension des éléments à la basse tension, le tube accélérateur 7 comporte donc une structure isolante 12 qui est disposée en aval de la bride support 8. La structure isolante 12 présente une extrémité amont 15 qui est au potentiel de la bride support 8 et de la chambre 1, et une extrémité aval 16 qui est au potentiel de la ligne de transport 10. Pour cela, la structure isolante 12 est généralement une structure cylindrique isolante composée de céramiques 13 et d'anneaux métalliques 14 de répartition de potentiels disposés entre l'extrémité amont 15 et l'extrémité aval 16.

Le tube accélérateur 7 comporte également un système d'extraction qui comporte plusieurs électrodes 11a à 11e qui permettent de former un faisceau d'ions en sortie de la chambre plasma 1. Le tube accélérateur 7 est connecté à une manchette de pompage 17, en aval des électrodes 11a à 11e, qui permet d'éviter un claquage entre les électrodes.

Plus précisément, le système d'extraction comporte une première électrode 11a qui est disposée en sortie de la chambre 1. Cette première électrode 11a percée réalise l'orifice de sortie de la chambre plasma. Cette première électrode 11a est à la haute tension et elle est reliée à la bride support 8.

Le système d'extraction comporte également une deuxième électrode 11b qui est reliée à un des anneaux métalliques 14 de répartition de potentiel. Cette deuxième électrode 11b est à un potentiel variable en fonction des espèces que l'on veut extraire en dehors de la chambre. Le potentiel de la deuxième électrode 11b possède une polarisation indépendante.

Le système d'extraction comporte ensuite deux électrodes 11c et 11d qui sont reliées à l'extrémité aval 16 du tube accélérateur 7 et qui sont au même potentiel que l'extrémité aval du tube accélérateur 7 c'est-à-dire au potentiel de ligne de transport 10.

Le système d'extraction comporte ensuite une cinquième électrode 11e disposée entre les électrodes 11c et 11d qui est à un potentiel négatif par rapport au potentiel de la ligne de transport 10 afin d'éviter que les électrons ne retournent dans la chambre plasma 1.

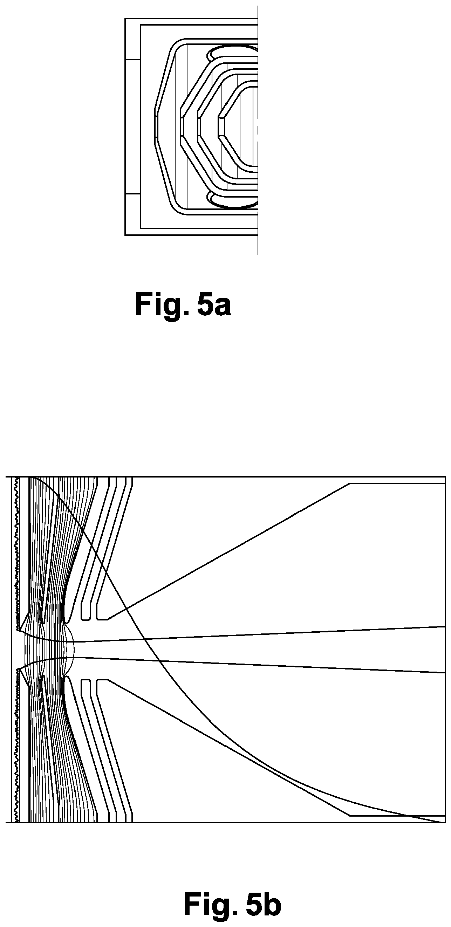

Les électrodes 11a à 11e permettent d'accélérer et de guider le faisceau d'ions en sortie de la chambre 1. Le contour de chaque électrode est optimisé afin d'éviter d'une part tout claquage électrique et d'autre part toute aberration géométrique dans la focalisation du faisceau. La région de l'espace pour laquelle le profil des électrodes conditionne l'extraction du faisceau est comprise à l'intérieur de la zone représentée sur la figure 5a, dans laquelle les distances inter-électrodes, les épaisseurs, les angles, et les congés de chacune des électrodes caractérisent complètement le faisceau extrait. Au-delà de cette zone critique l'électrode 11b est raccordée à un des anneaux métalliques 14 de répartition de potentiel afin de pouvoir la polariser indépendamment. Les électrodes 11c et 11d sont raccordées à la bride aval 16 du tube accélérateur 7 afin de les porter au potentiel de la ligne de transport 10. L'électrode 11e est fixée sur l'électrode 11c grâce à des entretoises isolantes et est portée à un potentiel négatif par rapport à la ligne de transport 10.

Les raccordements électriques et mécaniques de ces électrodes 11 doivent être compatibles avec la limitation du champ électrique dans le tube accélérateur, ce qui implique une optimisation des formes des électrodes et des distances qui les séparent. Cela aboutit à une structure par emboîtement successif des électrodes d'autant plus complexe que le nombre d'électrode croit et à une quantité de matière importante pour leur fabrication.

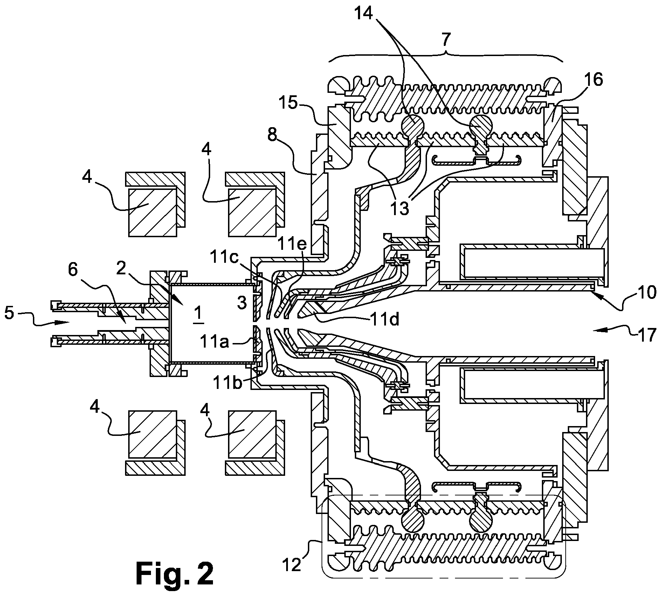

Par ailleurs, la structure isolante 12 du tube accélérateur entoure les électrodes du système d'extraction et par conséquent, elle présente un diamètre important et une longueur importante de sorte que le dispositif des figures 1 et 2 est très encombrant.

Par ailleurs, les moyens de génération d'un champ magnétique 4, qui comportent le plus souvent des bobines, sont à la haute-tension de sorte qu'un transformateur d'isolement doit être utilisé pour alimenter les bobines en énergie, ce qui complique la conception du dispositif.

En outre, il a été constaté que le pompage au travers de la ligne de transport 10 peut être insuffisant pour éviter un claquage entre les électrodes.

Par ailleurs, le dispositif de la figure 1 comporte des solénoïdes 30 disposés le long de la ligne de transport 10 qui permettent de refocaliser le faisceau d'ions le long de la ligne de transport 10. A partir de l'électrode 11d jusqu'à la sortie du tube accélérateur 7 le faisceau diverge par répulsion électrostatique des charges du faisceau entre elles, entrainant une taille importante de faisceau et une divergence importante du faisceau à la sortie du tube accélérateur 7. Le premier solénoïde 30 ne peut être positionné qu'en aval du tube accélérateur 7. La focalisation du faisceau n'intervient qu'à la sortie du tube accélérateur 7 entrainant une dégradation de la brillance du faisceau produit.

En outre, le poids de l'ensemble formé de la chambre 1, du système d'extraction 11, du système magnétique 4 et de la structure isolante 12 rend difficile son support par la seule bride support 8. La bride support 8 qui est à la haute-tension permet de supporter le système magnétique ainsi que la chambre plasma. Elle doit donc reposer sur une plateforme 9 isolée de la ligne de transport ce qui permet de reprendre les efforts mécaniques, d'assurer le centrage de l'ensemble ainsi que l'étanchéité au vide. Toutefois, la présence de la plate-forme rend le dispositif volumineux et lourd.

Le document JP H06-19961 B2 décrit un dispositif générateur d'ions comportant une chambre plasma, des moyens de génération d'un champ magnétique dans la chambre plasma, la chambre plasma étant à un premier potentiel, les moyens de génération d'un champ magnétique étant à un deuxième potentiel, et des moyens de propagation d'une onde haute-fréquence à l'intérieur de la chambre plasma.

**EXPOSE DE L'INVENTION**

L'invention vise à remédier aux inconvénients de l'état de la technique en proposant un dispositif générateur d'ions à résonance cyclotronique électronique qui est moins encombrant que ceux de l'art antérieur.

Un autre objet de l'invention est de proposer un dispositif générateur d'ions à résonance cyclotronique électronique qui est moins lourd que ceux de l'art antérieur.

Un autre objet de l'invention est de proposer un dispositif générateur d'ions à résonance cyclotronique électronique de conception plus simple que ceux de l'art antérieur.

L'invention vise également à proposer un dispositif générateur d'ions à résonance cyclotronique électronique qui permet d'avoir un faisceau d'ions mieux focalisé.

Pour ce faire, est proposé selon un premier aspect de l'invention, un dispositif générateur d'ions à résonance cyclotronique électronique comportant :

- une chambre plasma destinée à contenir un plasma ;
- des moyens de génération d'un champ magnétique permettant la résonance cyclotronique électronique dans la chambre plasma, la chambre plasma étant à un premier potentiel, les moyens de génération d'un champ magnétique étant à un deuxième potentiel,
- des moyens de propagation d'une onde haute-fréquence à l'intérieur de la chambre plasma,
- une structure isolante, la structure isolante présentant une extrémité amont qui est au premier potentiel et une extrémité aval qui est au deuxième potentiel,

l'extrémité aval de ladite structure isolante étant disposée en amont de la chambre plasma ; et les moyens de génération d'un champ magnétique étant situés en aval de l'extrémité aval de la structure isolante.

Les termes « aval » et « amont » sont utilisés en référence à un élément du système et par rapport au sens de propagation du faisceau d'ions en sortie de la chambre plasma.

Au contraire des dispositifs de l'art antérieur, les moyens de génération d'un champ magnétique, qui comportent généralement au moins une bobine, ne sont plus disposés en amont de la structure isolante mais en aval. En effet, au lieu de disposer les moyens de génération d'un champ magnétique autour de l'endroit où l'on veut créer le champ magnétique, l'invention propose de décaler ces moyens de génération en aval de l'endroit où l'on veut créer le champ magnétique et d'utiliser le champ de fuite issu de ces moyens de génération d'un champ magnétique au lieu d'utiliser le champ magnétique maximal produit par les moyens de génération d'un champ magnétique.

Le fait de décaler les moyens de génération d'un champ magnétique en aval de la structure isolante permet à la fois de libérer de l'espace autour de la chambre plasma ce qui permet de simplifier la conception du dispositif générateur d'ions mais aussi de focaliser le faisceau d'ions en sortie de chambre :

- en effet, les moyens de génération d'un champ magnétique sont en aval de la structure isolante et sont à un deuxième potentiel ;

- la distance relative entre le côté amont de la chambre plasma et les moyens de génération d'un champ magnétique est imposée par l'obtention de la condition de résonnance dans la chambre plasma,

- le champ magnétique généré dans la zone située au plus proche des moyens de génération d'un champ magnétique permet de focaliser le faisceau d'ions qui traverse le système d'extraction, tandis que le champ magnétique de fuite produit par les moyens de génération d'un champ magnétique permet de produire une résonance cyclotronique électronique dans la chambre plasma.

Les moyens de génération d'un champ magnétique permettent donc de réaliser à la fois le champ magnétique qui permet la résonance cyclotronique électronique dans le chambre plasma et le champ magnétique qui permet de focaliser le faisceau d'ions dans le système d'extraction.

Le premier potentiel est de préférence différent du deuxième potentiel.

En effet, dans les dispositifs de l'art antérieur, la chambre plasma et les moyens de génération d'un champ magnétique sont au même potentiel, qui correspond à la haute-tension, ce qui conduit à la nécessité d'utiliser une plate-forme d'isolation pour les supporter. En outre, un transformateur d'isolement doit être utilisé pour alimenter les moyens de génération d'un champ magnétique en énergie, ce qui complique la composition du dispositif. Au contraire, selon l'invention, les moyens de génération d'un champ magnétique ne sont plus au même potentiel que la chambre plasma, de sorte qu'aucune plate-forme d'isolation n'est plus nécessaire. En outre, l'alimentation des moyens de génération d'un champ magnétique est simplifiée.

L'extrémité amont de la structure isolante est reliée aux parties du dispositif qui sont au premier potentiel, tandis que les parties du dispositif qui sont au deuxième potentiel sont reliées à l'extrémité aval de la structure isolante. La structure isolante permet donc d'isoler électriquement les parties du dispositif qui sont au premier potentiel de celles qui sont au deuxième potentiel.

Le dispositif selon l'invention peut également comporter une ou plusieurs des caractéristiques décrites ci-dessous prises individuellement ou selon toutes les combinaisons techniquement possibles.

Le dispositif est de préférence une source d'ions mono-chargés de type ECR. Cette source d'ions mono-chargés est destinée principalement à l'injection de faisceaux d'ions de forte brillance dans des accélérateurs de particules. L'extraction directe dans le champ magnétique permet de limiter l'extension radiale du faisceau dès sa formation dans l'électrode plasma, et donc les pertes de particules sur les parois de la chambre à vide de la ligne de transport.

Selon un mode de réalisation préférentiel, les moyens de génération d'un champ magnétique sont entièrement situés en aval de la chambre plasma.

Selon un mode de réalisation, le dispositif comporte en outre un système d'extraction apte à former un faisceau d'ions en sortie de la chambre plasma.

Avantageusement, le système d'extraction est situé en aval de la chambre plasma.

Avantageusement, le système d'extraction comporte plusieurs électrodes.

Avantageusement, la chambre présente un côté aval percé par un orifice de sortie.

Avantageusement, le système d'extraction comporte une première électrode, disposée le long du côté aval de la chambre.

Les moyens de génération d'un champ magnétique sont de préférence disposés en aval de la première électrode du système d'extraction, de sorte qu'ils permettent de focaliser le faisceau extrait de la chambre plasma par la première électrode. Le dispositif permet ainsi de produire un faisceau de forte brillance.

Selon un mode de réalisation, au moins une partie des moyens de propagation d'une onde haute-fréquence est également au premier potentiel.

Selon un mode de réalisation, les parties du dispositif qui sont au premier potentiel sont à une haute tension.

Dans ce document, on appelle haute tension, une tension continue supérieure à 1000 volts et pouvant aller à plusieurs dizaines de milliers de volts. Le dispositif de génération d'ions comporte en outre de préférence un tube accélérateur.

Avantageusement, la structure isolante est située en amont de la chambre plasma, ce qui permet de réduire la longueur totale du dispositif.

En effet, la longueur du système d'extraction peut être ramenée à une distance de l'ordre de 50 mm quelle que soit l'énergie du faisceau extrait, en positionnant la structure isolante en amont de la chambre plasma.

La structure isolante est de préférence disposée autour d'au moins une partie des moyens de propagation d'une onde haute fréquence de façon à rendre le dispositif moins encombrant.

Selon un mode de réalisation préférentiel, la structure isolante comporte des tubes isolant en céramique.

Avantageusement, la structure isolante comporte en outre des anneaux métalliques de répartition de potentiel.

Avantageusement, l'extrémité amont de la structure isolante est pourvue d'une première bride métallique.

Avantageusement, l'extrémité aval de la structure isolante est pourvue d'une deuxième bride métallique.

Selon un mode de réalisation, le dispositif comporte en outre une bride support qui supporte la structure isolante.

Avantageusement, la bride support supporte également les moyens de génération d'un champ magnétique.

Avantageusement, la bride support supporte également le système d'extraction.

Avantageusement, la chambre plasma est reliée à la bride support par l'intermédiaire de la structure isolante. Ainsi, la bride support est isolée électriquement de la chambre plasma.

La chambre plasma est de préférence disposée entre la structure isolante et la bride support.

Avantageusement, la bride support est au même potentiel que les moyens de génération d'un champ magnétique.

La bride support est de préférence disposée en amont des moyens de génération d'un champ magnétique.

Selon un mode de réalisation, les moyens de génération d'un champ magnétique comportent un solénoïde, ce qui permet de créer un champ magnétique suffisamment important pour que la résonnance cyclotronique électronique ait lieu dans la chambre plasma.

Toutefois, on pourrait également envisager de réaliser l'invention avec des moyens de génération d'un champ magnétique formés par des aimants.

Selon différents modes de réalisation, le système d'extraction peut comporter une ou plusieurs des électrodes suivantes:

- une première électrode reliée à la chambre plasma ; la première électrode est au premier potentiel, c'est-à-dire au même potentiel que la chambre plasma ;

- une deuxième électrode reliée à un point de la structure isolante situé entre son extrémité amont et son extrémité aval ; cette deuxième électrode peut être portée à un potentiel variable en fonction des espèces à extraire de la chambre plasma. Cette deuxième électrode est en aval de la première électrode et elle est reliée à la structure isolante qui est non seulement en amont de la première électrode, mais également en amont de la chambre plasma ; le point de la structure isolante auquel est reliée cette deuxième électrode est choisi en fonction du potentiel auquel on veut placer la deuxième électrode ;

- une troisième et une quatrième électrode reliées à la bride support ; la troisième et la quatrième électrode sont de préférence au deuxième potentiel ; Le fait de placer la bride support au deuxième potentiel permet de simplifier la conception des troisième et quatrième électrodes puisque de cette façon, les troisième et quatrième électrodes peuvent être reliées à la bride support au lieu d'être reliée à la structure isolante, ce qui permet d'avoir des électrodes plus courtes. En effet, la bride support est de préférence située en amont du système d'extraction ;

- une cinquième électrode située entre la troisième et la quatrième électrode, la cinquième électrode étant à un potentiel négatif par rapport au deuxième potentiel.

Ainsi, au lieu d'avoir les connexions des électrodes vers l'aval du faisceau, seule la deuxième électrode portée à un potentiel intermédiaire entre le potentiel de la ligne de transport et la haute-tension doit être reliée à la structure isolante du tube accélérateur. C'est maintenant la seule électrode de géométrie complexe. La géométrie des électrodes est donc considérablement simplifiée.

Avantageusement, le dispositif comporte en outre une manchette de pompage disposée entre les moyens de génération d'un champ magnétique et la structure isolante, afin d'optimiser les conditions de fonctionnement tout en baissant la pression dans le système d'extraction. Ainsi, la manchette de pompage se situe au plus près du système d'extraction.

Avantageusement, les moyens de générations d'un champ magnétique sont disposés autour du système d'extraction, renforçant la focalisation du faisceau extrait.

## BREVES DESCRIPTION DES FIGURES

D'autres caractéristiques et avantages de l'invention ressortiront à la lecture de la description détaillée qui suit, en référence aux figures annexées, qui illustrent :

- La figure 1, une vue de côté d'un dispositif générateur d'ions de l'art antérieur et de la ligne de transport basse énergie (LBE);

- La figure 2, une vue en coupe du dispositif générateur d'ions de la figure 1 ;

- La figure 3, une vue en perspective de l'extérieur du dispositif de la figure 1 ;

- La figure 4, une coupe en perspective de l'intérieur du dispositif de la figure 1 ;

- La figure 5a, une vue en coupe agrandie des électrodes du dispositif générateur d'ions de la figure 2

- La figure 5b, une simulation du faisceau extrait au travers des électrodes de la figure 5a;

- La figure 6, une vue en coupe d'un dispositif générateur d'ions selon un mode de réalisation de l'invention ;

- La figure 7, une vue en perspective du dispositif de la figure 6 vu de l'extérieur ;

- La figure 8, une coupe en perspective de l'intérieur du dispositif de la figure 7 ;

- La figure 9, une vue en coupe comparative entre deux dispositifs de l'art antérieur et un dispositif selon un mode de réalisation de l'invention ;

- La figure 10, une courbe qui représente le champ magnétique dans les trois dispositifs de la figure 9.

Pour plus de clarté, les éléments identiques ou similaires sont repérés par des signes de références identiques sur l'ensemble des figures.

## DESCRIPTION DETAILLEE D'AU MOINS UN MODE DE REALISATION

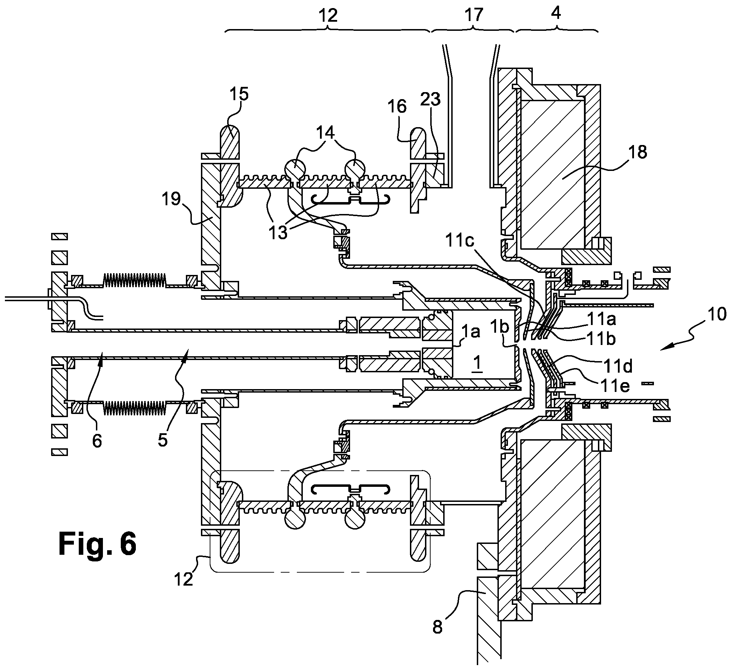

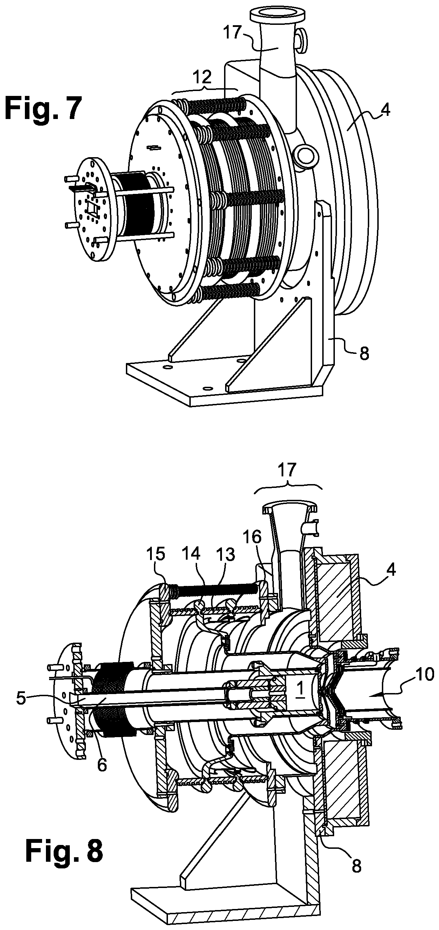

Les figures 6 à 8 représentent un dispositif générateur d'ions à résonance cyclotronique électronique selon un mode de réalisation de l'invention.

Le dispositif générateur d'ions à résonance cyclotronique électronique comporte une chambre plasma 1 apte à contenir un plasma.

La chambre plasma 1 comporte un côté amont 2 sur lequel se situe un orifice d'entrée 1a de la chambre dans lequel une onde haute-fréquence peut être injectée, et un côté aval 3 dans lequel se situe un orifice de sortie 1b par lequel un faisceau d'ions peut sortir.

Le dispositif comporte également des moyens de propagation d'une onde haute-fréquence 5 à l'intérieur de la chambre. Ces moyens de propagation d'une onde haute-fréquence 5 comportent de préférence un système de génération d'une onde haute-fréquence (non représenté) et des moyens de guidage 6 de l'onde haute-fréquence jusqu'à l'orifice d'entrée 1a de la chambre plasma 1. Les moyens de propagation de l'onde haute-fréquence 5 sont disposés en amont de la chambre plasma 1.

La chambre plasma 1 et au moins une partie des moyens de propagation d'une onde haute-fréquence 5 sont à un premier potentiel. Dans le cas présent, la chambre plasma 1 et au moins une partie des moyens de propagation d'une onde haute-fréquence 5 sont à la haute-tension, dans le cas présent à une tension continue de l'ordre de 100 000 V.

Le dispositif comporte également une manchette de pompage 17 qui est disposée autour de la chambre plasma 1. Cette manchette de pompage 17 permet notamment d'assurer un vide suffisant au niveau des électrodes 11a à 11e du système d'extraction pour éviter les claquages, et de maintenir un vide de l'ordre de $10^{-3}$ mbar dans la chambre plasma 1 permettant la formation du plasma.

Le dispositif comporte également une bride support 8 qui forme l'armature du dispositif et qui permet de supporter l'ensemble du dispositif. La bride support 8 est à un deuxième potentiel. Le deuxième potentiel est généralement inférieur au premier potentiel.

Le dispositif comporte également des moyens de génération d'un champ magnétique 4. Ces moyens de génération d'un champ magnétique 4 comportent de préférence une bobine 18, toutefois ces moyens de génération d'un champ magnétique 4 pourraient également comporter un ou plusieurs aimants. Les moyens de génération d'un champ magnétique 4 sont au deuxième potentiel.

Les moyens de génération d'un champ magnétique 4 sont en aval de la chambre plasma 1 et en aval de la bride support 8.

Le dispositif comporte également un tube accélérateur qui comporte une structure isolante 12. La structure isolante 12 comporte une extrémité amont 15 qui est au premier potentiel et une extrémité aval 16 qui est au deuxième potentiel. L'extrémité amont 15 est connectée sur une première bride 19 métallique au premier potentiel. L'extrémité aval 16 est connectée sur la bride amont 23 de la manchette de pompage 17 au deuxième potentiel.

La structure isolante 12 est constituée de tubes isolants en céramique 13 qui permettent d'isoler les éléments connectés à l'extrémité amont 15 de la structure isolante de ceux connectés à son extrémité aval 16. La structure isolante 12 comporte également des anneaux métalliques 14 disposés entre l'extrémité amont 15 et l'extrémité aval 16. Les tubes métalliques 14 sont à différents potentiels compris entre le potentiel de l'extrémité amont 15 et celui de l'extrémité aval 16.

La structure isolante 12 est disposée en amont de la chambre plasma 1.

La structure isolante 12 est de préférence disposée autour d'au moins une partie des moyens de propagation d'une onde haute-fréquence 5, et plus précisément autour du guide d'onde 6 des moyens de propagation d'une onde haute-fréquence 5.

Le tube accélérateur comporte également un système d'extraction 11 qui permet de former un faisceau d'ions en sortie de la chambre plasma 1. Le système d'extraction 11 est de préférence situé en aval de la chambre plasma 1.

Le système d'extraction 11 comporte de préférence plusieurs électrodes.

Dans ce mode de réalisation, le système d'extraction 11 comporte cinq électrodes 11a à 11e :

- la première électrode 11a est reliée à la chambre plasma. Plus précisément, la première électrode 11a est disposée le long du côté aval de la chambre plasma 1. Elle est percée et elle entoure l'orifice de sortie 1b de la chambre plasma 1. La première électrode 11a est au premier potentiel, c'est-à-dire au même potentiel que la chambre plasma ;

- la deuxième électrode 11b est reliée à un point de la structure isolante 12 situé entre l'extrémité amont 15 et l'extrémité aval 16. Cette deuxième électrode 11b peut être placée à un potentiel variable en fonction des espèces à extraire de la chambre plasma. Le point de la structure isolante 12 auquel est reliée cette deuxième électrode est choisi en fonction du potentiel auquel on veut placer la deuxième électrode. Cette deuxième électrode 11b est en aval de la première électrode 11a et elle est reliée à la structure isolante 12 ;

- une troisième électrode 11c et une quatrième électrode 11d reliées à la bride support 8; la troisième électrode 11c et la quatrième électrode 11d sont de préférence au deuxième potentiel ;

- une cinquième électrode 11e située entre la troisième électrode 11c et la quatrième électrode 11d, la cinquième électrode 11e étant à un potentiel négatif par rapport au deuxième potentiel.

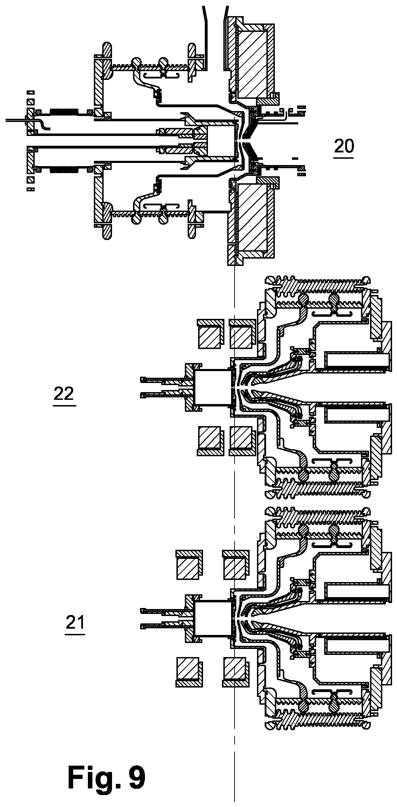

La figure 9 représente l'espace occupé par :

- un dispositif 20 identique à celui décrit en référence aux figures 6 à 8 ;

- un premier dispositif 21 de l'art antérieur identique à celui décrit en référence aux figures 1 à 4 ;

- un deuxième dispositif 22 de l'art antérieur identique à celui des figures 1 à 4 à l'exception du fait que les moyens de génération d'un champ magnétique sont légèrement décalés vers la bride support.

Comme on peut le voir sur la figure 9, le dispositif selon l'invention permet de réduire l'espace occupé en aval du dispositif.

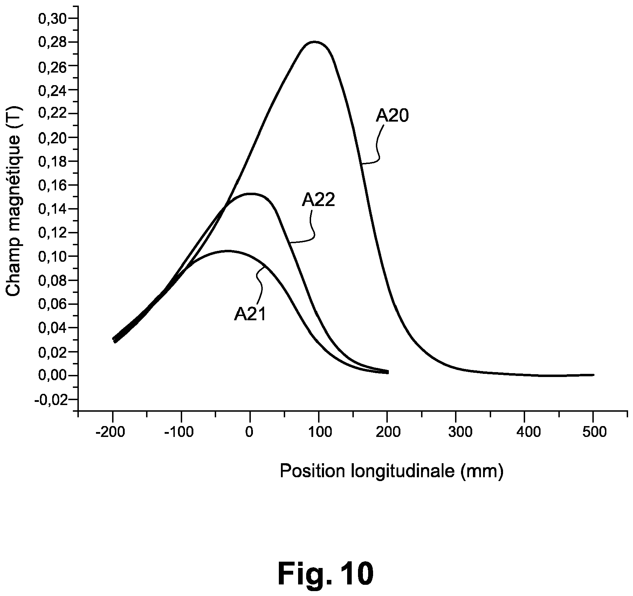

La figure 10 représente le champ magnétique en fonction de la position longitudinale dans chacun des dispositifs de la figure 9. Plus précisément, la courbe $A_{20}$ représente l'évolution du champ magnétique en fonction de la position longitudinale dans le dispositif 20. La courbe $A_{21}$ représente l'évolution du champ magnétique en fonction de la position longitudinale dans le dispositif 21. La courbe $A_{22}$ représente l'évolution du champ magnétique en fonction de la position longitudinale dans le dispositif 22. Comme on peut le voir sur ces figures, le champ magnétique créé en aval du dispositif 20 est plus important que les champs magnétiques créés en aval des dispositifs 21 et 22 du fait de la disposition des moyens de génération d'un champ magnétique en aval du dispositif 20 selon l'invention et du fait que la bobine 18 utilisée dans le dispositif selon l'invention présente des dimensions plus importantes que les dispositifs de l'art antérieur. Ce champ magnétique plus important en aval du dispositif permet de focaliser le faisceau d'ions en sortie de la chambre plasma.

Naturellement, l'invention n'est pas limitée aux modes de réalisations décrits en référence aux figures et des variantes pourraient être envisagées sans sortir du cadre de l'invention.

## Revendications

1. Dispositif générateur d'ions à résonance cyclotronique électronique comportant :

    - une chambre plasma (1) destinée à contenir un plasma ;
    - des moyens de génération d'un champ magnétique (4) permettant la résonance cyclotronique électrique dans la chambre plasma, la chambre plasma (1) étant à un premier potentiel, les moyens de génération d'un champ magnétique (4) étant à un deuxième potentiel,
    - des moyens de propagation d'une onde haute-fréquence (5) à l'intérieur de la chambre plasma,
    - une structure isolante (12), la structure isolante (12) présentant une extrémité amont (15) qui est au premier potentiel et une extrémité aval (16) qui est au deuxième potentiel,

    l'extrémité aval de ladite structure isolante étant disposée en amont de la chambre à plasma (1) et les moyens de génération d'un champ magnétique (4) étant situés en aval de l'extrémité aval de la structure isolante (12).

2. Dispositif selon la revendication précédente, **caractérisé en ce que** la structure isolante (12) est disposée autour d'au moins une partie des moyens de propagation d'une onde haute fréquence (5).

3. Dispositif selon l'une quelconque des revendications précédentes, **caractérisé en ce qu'**il comporte en outre une manchette de pompage (17) disposée entre les moyens de génération d'un champ magnétique (4) et la structure isolante (12).

4. Dispositif selon l'une quelconque des revendications précédentes, **caractérisé en ce qu'**il comporte en outre un système d'extraction (11) apte à former un faisceau d'ions en sortie de la chambre plasma (1).

5. Dispositif selon la revendication précédente, **caractérisé en ce que** le système d'extraction (11) est situé en aval de la chambre plasma (1).

6. Dispositif selon l'une quelconque des revendications précédentes, **caractérisé en ce que** la chambre plasma (1) présente un côté aval percé par un orifice de sortie (1b), le système d'extraction (11) comportant une première électrode (11a), disposée le long du côté aval de la chambre plasma (1).

7. Dispositif selon l'une quelconque des revendications précédentes, **caractérisé en ce qu'**au moins une partie des moyens de propagation d'une onde haute-fréquence (5) est également au premier potentiel.

8. Dispositif selon l'une quelconque des revendications précédentes, **caractérisé en ce qu'**il comporte en outre une bride support (8) qui supporte la structure isolante (12) ainsi que les moyens de génération d'un champ magnétique (4).

9. Dispositif selon la revendication précédente, **caractérisé en ce que** la chambre plasma (1) est disposée entre la structure isolante (12) et la bride support (8).

10. Dispositif selon l'une quelconque des revendications 8 ou 9, **caractérisé en ce que** la bride support (8) est au même potentiel que les moyens de génération d'un champ magnétique (4).

11. Dispositif selon l'une quelconque des revendications 8 à 10, **caractérisé en ce que** la bride support (8) est disposée en amont des moyens de génération d'un champ magnétique (4).

## Patentansprüche

1. Ionengenerator-Vorrichtung mit elektronischer Zyklotronresonanz, umfassend:

    - eine Plasmakammer (1), die dazu bestimmt ist, ein Plasma zu enthalten;
    - Mittel zum Erzeugen eines Magnetfeldes (4), die die elektrische Zyklotronresonanz in der Plasmakammer zulassen, wobei die Plasmakammer (1) an einem ersten Potenzial ist, wobei die Erzeugungsmittel eines Magnetfeldes (4) an einem zweiten Potenzial sind,
    - Verbreitungsmittel einer Hochfrequenzelle (5) im Innern der Plasmakammer,
    - eine isolierende Struktur (12), wobei die isolierende Struktur (12) ein vorgeschaltetes Ende (15), das am ersten Potenzial ist, und ein nachgeschaltetes Ende (16), das am zweiten Potenzial ist, aufweist,

wobei das nachgeschaltete Ende der genannten isolierenden Struktur der Plasmakammer (1) vorgeschaltet ist und die Erzeugungsmittel eines Magnetfeldes (4) dem nachgeschalteten Ende der isolierenden Struktur (12) nachgeschaltet angeordnet sind.

2. Vorrichtung gemäß dem voranstehenden Anspruch, **dadurch gekennzeichnet, dass** die isolierende Struktur (12) um wenigstens einen Teil der Verbreitungsmittel einer Hochfrequenzwelle (5) angeordnet sind.

3. Vorrichtung gemäß irgendeinem der voranstehenden Ansprüche, **dadurch gekennzeichnet, dass** sie darüber hinaus einen Pumpstutzen (17) umfasst, der zwischen den Mitteln zum Erzeugen eines Magnetfeldes (4) und der isolierenden Struktur (12) angeordnet sind.

4. Vorrichtung gemäß irgendeinem der voranstehenden Ansprüche, **dadurch gekennzeichnet, dass** sie darüber hinaus ein Extraktionssystem (11) umfasst, das geeignet ist, einen Ionenstrahl am Ausgang der Plasmakammer (1) zu bilden.

5. Vorrichtung gemäß dem voranstehenden Anspruch, **dadurch gekennzeichnet, dass** das Extraktionssystem (11) der Plasmakammer (1) nachgeschaltet angeordnet ist.

6. Vorrichtung gemäß irgendeinem der voranstehenden Ansprüche, **dadurch gekennzeichnet, dass** die Plasmakammer (1) eine nachgeschaltete Seite aufweist, die von einer Ausgangsöffnung (1b) durchbrochen ist, wobei das Extraktionssystem (11) eine erste Elektrode (11a) umfasst, die entlang der der Plasmakammer (1) nachgeschalteten Seite angeordnet ist.

7. Vorrichtung gemäß irgendeinem der voranstehenden Ansprüche, **dadurch gekennzeichnet, dass** wenigstens ein Teil der Verbreitungsmittel einer Hochfrequenzwelle (5) ebenfalls am ersten Potenzial ist.

8. Vorrichtung gemäß irgendeinem der voranstehenden Ansprüche, **dadurch gekennzeichnet, dass** sie darüber hinaus einen Trägerflansch (8), der die isolierende Struktur (12) trägt, sowie Mittel zum Erzeugen eines Magnetfeldes (4) umfasst.

9. Vorrichtung gemäß dem voranstehenden Anspruch, **dadurch gekennzeichnet, dass** die Plasmakammer (1) zwischen der isolierenden Struktur (12) und dem Trägerflansch (8) angeordnet ist.

10. Vorrichtung gemäß irgendeinem der Ansprüche 8 oder 9, **dadurch gekennzeichnet, dass** der Trägerflansch (8) an demselben Potenzial ist wie die Mittel zum Erzeugen eines Magnetfeldes (4).

11. Vorrichtung gemäß irgendeinem der Ansprüche 8 bis 10, **dadurch gekennzeichnet, dass** der Trägerflansch (8) den Mitteln zum Erzeugen eines Magnetfeldes (4) vorgeschaltet angeordnet ist.

## Claims

1. A ion generator device with electron cyclotron resonance including:

   - a plasma chamber (1) for containing a plasma;
   - magnetic field generation means (4) allowing the electric cyclotron resonance in the plasma chamber, the plasma chamber (1) being at a first potential, the magnetic field generation means (4) being at a second potential,
   - propagation means (5) for propagating a high frequency wave inside the plasma chamber,
   - an insulating structure (12), the insulating structure (12) having an upstream end (15) which is at the first potential and a downstream end (16) which is at the second potential,

   the downstream end of said insulating structure being disposed upstream of the plasma chamber (1) and the magnetic field generation means (4) being located downstream of the downstream end of the insulating structure (12).

2. The device according to the preceding claim, **characterised in that** the insulating structure (12) is disposed about at least part of the high frequency wave propagation means (5).

3. The device according to any of the preceding claims, **characterised in that** it further includes a pumping handle (17) disposed between the magnetic field generation means (4) and the insulating structure (12).

4. The device according to any of the preceding claims, **characterised in that** it further includes an extraction system (11) able to form a ion beam at the output from the plasma chamber (1).

5. The device according to the preceding claim, **characterised in that** the extraction system (11) is located downstream of the plasma chamber (1).

6. The device according to any of the preceding claims, **characterised in that** the plasma chamber (1) has a downstream side pierced with an outlet port (1b), the extraction system (11) including a first electrode (11a), disposed along the downstream side of the plasma chamber (1).

7. The device according to any of the preceding claims, **characterised in that** at least part of the high frequency wave propagation means (5) is also at the first potential.

8. The device according to any of the preceding claims, **characterised in that** it further includes a support flange (8) which supports the insulating structure (12) as well as the magnetic field generation means (4).

9. The device according to the preceding claim, **characterised in that** the plasma chamber (1) is disposed between the insulating structure (12) and the support flange (8).

10. The device according to any of claims 8 or 9, **characterised in that** the support flange (8) is at the same potential as the magnetic field generation means (4).

11. The device according to any of claims 8 to 10, **characterised in that** the support flange (8) is disposed upstream of the magnetic field generation means (4).

**Fig. 1**

**Fig. 2**

EP 2 652 766 B1

**Fig. 3**

**Fig. 4**

**Fig. 5a**

**Fig. 5b**

Fig. 6

EP 2 652 766 B1

Fig. 7

Fig. 8

**Fig. 9**

**Fig. 10**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- JP H0619961 B

**Littérature non-brevet citée dans la description**

- Status and new developments of the high intensity electron cyclotron resonance source light ion continuous wave, and pulsed mode. *RSI 71,* Février 2000, vol. 2, 830
- Status of the light ion source developments at CEA-Saclay. *RSI 73,* Mai 2004, vol. 5 (1414
- Electron cyclotron resonance 140 mA D+ beam extraction optimization for IFMIF EVEDA accelerator. *RSI 79 02B723,* 2008
- A 140mA cW deuteron electron cyclotron resonance source for the IFMIF-EVEDA Project. *Review of Scientific Instruments,* 16 Janvier 2008, vol. 79 (2), 2B303